# EUROPÄISCHE PATENTSCHRIFT

(11) **EP 1 360 726 B1**
(45) Veröffentlichungstag und Bekanntmachung des Hinweises auf die Patenterteilung: **19.03.2008**
(21) Anmeldenummer: 02706607.5
(22) Anmeldetag: 21.01.2002
(51) Int. Cl.: H01L 23/60

(54) **Halbleiter-Bauelement mit ESD-Schutz**
Semiconductor component comprising ESD protection
Composant à semi-conducteurs comportant une protection contre les décharges électrostatiques

(30) Priorität: 19.01.2001 DE 10102354
(43) Veröffentlichungstag der Anmeldung: 12.11.2003
(73) Patentinhaber: Qimonda AG, 81739 München (DE)
(72) Erfinder: TROOST, Marco, 81477 München (DE)
(74) Vertreter: Epping - Hermann - Fischer
(86) Internationale Anmeldenummer: PCT/DE2002/000175
(87) Internationale Veröffentlichungsnummer: WO 2002/058154

(56) Entgegenhaltungen:
- EP-A- 0 412 561
- EP-A- 0 623 958
- EP-A- 0 736 904
- DE-A- 19 507 313
- US-A- 5 886 862
- PATENT ABSTRACTS OF JAPAN vol. 015, no. 390 (E-1118), 3. Oktober 1991 (1991-10-03) -& JP 03 156965 A (FUJITSU LTD), 4. Juli 1991 (1991-07-04)

## Beschreibung

Die Erfindung betrifft ein Halbleiter-Bauelement gemäß den Merkmalen des Oberbegriffs des Patentanspruchs 1.

Integrierten Schaltungen werden von außen Versorgungspotentiale sowie zu verarbeitende Eingangssignale zugeführt und verarbeitete Ausgangssignale abgegriffen. Insbesondere die Eingangssignalanschlüsse sind sehr empfindlich, da die der Zuführung dienenden Leiterbahnen direkt auf einen Gate-Anschluß einer Eingangsschaltstufe führen. Bei der manuellen Handhabung der integrierten Schaltung oder der automatisierten Weiterverarbeitung, um die integrierte Schaltung auf einer Schaltungsplatine zu plazieren und zu verlöten, besteht die Gefahr, daß die empfindliche Eingangsstufe bzw. Ausgangsstufe aufgrund der Entladung von elektrostatischen Ladungen zerstört wird. So kann der menschliche Körper elektrostatisch geladen sein, welche Ladungen sich dann über die nach außen geführten Anschlüsse des die integrierte Schaltung enthaltenden Halbleiter-Bauelements entladen. Auch Werkzeuge von Bestückungsautomaten oder Testausrüstung können elektrostatisch geladen sind und sich über das Halbleiter-Bauelement entladen. Mit immer geringeren Strukturbreiten auf dem die integrierte Schaltung tragenden Halbleiterkörper besteht eine Notwendigkeit zum Schutz vor solchen elektrostatischen Entladungen.

Die US 5 646 434 zeigt Ausführungsbeispiele für Schutzelemente gegen elektrostatische Entladungen, sogenannte ESD-Schutzelemente (ESD: electrostatic discharge). Der Eingangsanschluß ist über eine ESD-Schutzstruktur, die im wesentlichen eine Diodenkennlinie aufweist, mit Bezugspotential (Masse) verbunden. Die ESD-Schutzstruktur ist vollständig im Halbleiterkörper realisiert. Die Schutzstruktur ist dabei so zu dimensionieren, daß sie beim Anlegen von zu verarbeitenden Signal innerhalb der vorgegebenen Spezifikation nicht schaltet und die Signalverläufe möglichst wenig dämpft. Die Diodenkennlinie muß daher eine hohe Durchbruchspannung aufweisen. Andererseits ist zu gewährleisten, daß im Falle einer elektrostatischen Entladung die Ladungsmenge niederohmig nach Masse abgeführt wird. Die verwendeten Dioden bzw. als Dioden geschaltete Transistoren müssen großflächig dimensioniert sein, um eine entsprechend hohe Stromtragfähigkeit aufzuweisen. Nachteilig ist daher, daß die ESD-Schutzstrukturen einen hohen Flächenverbrauch im Halbleiterkörper erfordern, um die gesetzten Randbedingungen nach hoher Durchbruchspannung und hoher Stromtragfähigkeit zu erfüllen.

Eine andere Halbleiterschaltung mit Schutzelementen gegen elektrostatische Entladungen ist in der EP 0 736 904 A1 gezeigt. Dort sind Schutzelemente zwischen einem Anschlußpad und auf dem Halbleiterchip verlaufenden Leiterbahnen angeordnet. Die Leiterbahnen verlaufen abschnittsweise parallel zum Rand des Halbleiterchips. Eine der Leiterbahnen bildet einen um den Halbleiterchip verlaufenden Ring.

Die Aufgabe der Erfindung besteht darin, ein Halbleiter-Bauelement anzugeben, bei dem der Flächenverbrauch im Halbleiterkörper möglichst gering ist, aber trotzdem ausreichend ESD-Schutz gewährleistet ist.

Diese Aufgabe wird durch ein Halbleiter-Bauelement gelöst, umfassend: einen Halbleiterkörper, in dem eine elektronische Schaltung angeordnet ist, die einen Anschluß für ein zu verarbeitendes Signal aufweist, an den eine Eingangsstufe oder Ausgangsstufe der elektronischen Schaltung angeschlossen ist, und die einen Anschluß für ein Versorgungspotential aufweist, an den die Eingangsstufe oder die Ausgangsstufe angeschlossen ist, je eine einem der Anschlüsse zugeordnete Leiterbahn, die außerhalb des Halbleiterkörpers verläuft und die mit dem jeweils zugeordneten Anschluß verbunden ist, ein Element zum Abführen elektrostatischer Entladungen, durch das eine am Anschluß für das zu verarbeitende Signal anliegende elektrostatische Entladung zum Versorgungspotential abführbar ist, bei dem außerdem eine weitere Leiterbahn vorgesehen ist, die außerhalb des Halbleiterkörpers verläuft und die mit der dem Anschluß für das Versorgungspotential zugeordneten Leiterbahn verbunden ist, und bei dem das Element zum Abführen elektrostatischer Ladungen außerhalb des Halbleiterkörpers angeordnet ist und einerseits mit der weiteren Leiterbahn und andererseits mit der dem Anschluß für das zu verarbeitende Signal zugeordneten Leiterbahn jeweils außerhalb des Halbleiterkörpers verbunden ist.

Beim Halbleiter-Bauelement gemäß der Erfindung sind die ESD-Elemente nicht mehr im Halbleiterkörper realisiert. Wie oben dargelegt, würde eine integrierte Ausführung von ESD-Schutzstrukturen nicht unbeachtlich Fläche verbrauchen. Dieser Flächenverbrauch wird beim Halbleiter-Bauelement gemäß der Erfindung gespart. Statt dessen sind die ESD-Schutzelemente außerhalb des Halbleiterkörpers angeordnet. Zusätzlich ist eine weitere Leiterbahn vorgesehen, die Versorgungspotential, vorzugsweise Masse, führt und an denjenigen Leiterbahnen vorbei geführt wird, über die den Funktionseinheiten des Halbleiterkörpers die Ein- oder Ausgangssignale ein- bzw. ausgegeben werden. Die Erfindung ist sowohl für wertdiskret, digital arbeitende Ein- und Ausgangsstufen als auch für wertkontinuierlich, analog arbeitende Ein- und Ausgangsstufen geeignet. Darüber hinaus ist vorteilhaft, daß das außerhalb des Halbleiterkörpers angeordnete ESD-Schutzelement nunmehr größer ausgeführt werden kann als bei integrierter Realisierung. Die ESD-Festigkeit wird dadurch erhöht.

Im integrierten Halbleiterchip sind sogenannte Anschlußpads vorgesehen, d.h. flächenhafte Metallisierungen, welche die Ein- oder Ausgangsanschlüsse der integrierten Schaltung darstellen. Metallische Leiterbahnen, die außerhalb des Halbleiterkörpers verlaufen, führen Versorgungspotentiale und zu verarbeitende Signale zu bzw. ab. Diese Leiterbahnen werden als sogenannter Leadframe bereitgestellt. Die dem Halbleiterkörper zugeordneten Enden der Leiterbahnen des Leadframes werden dann mittels Bonddrähten an die Anschlußpads kontaktiert. Die entgegengesetzten Enden der Leiterbahnen des Leadframes sind die Anschlußpins des Halbleiter-Bauelements und werden auf einer Schaltungsplatine verlötet oder in einen Sockel eingesteckt. Der Halbleiterkörper ist von einem Gehäuse, meist aus Plastik, umgeben, wobei die Leiterbahnen des Leadframes nach außen geführt sind, um Kontakt mit der Schaltungsplatine herzustellen.

Die gemäß der Erfindung zusätzlich vorzusehende weitere Leiterbahn umgibt den Halbleiterkörper. Der Halbleiterkörper ist meist rechteckig ausgeführt. Die weitere Leiterbahn verläuft dann zumindest teilweise parallel zu den Rändern des Halbleiterkörpers. Sie kreuzt dabei die von den Anschlußpads nach außen durch das Gehäuse geführten Leiterbahnen des Leadframes für die zu verarbeitenden Signal als auch für die Versorgungspotentiale.

Die Verbindung zwischen einer das Versorgungspotential (Masse) führenden Leiterbahn des Leadframes und der gemäß der Erfindung zusätzlich den Halbleiterkörper umgebenden Leiterbahn wird vorzugsweise durch eine Bondverbindung hergestellt. Die Massepotential führende zusätzliche Leiterbahn ist in Kreuzungspunkten mit einer ein zu verarbeitendes Signal führenden Leiterbahn des Leadframes über das ESD-Schutzelement verbunden. Das ESD-Schutzelement ist vorzugsweise eine Diode, deren Anodenanschluß mit der zusätzlichen Leiterbahn verbunden ist und deren Kathode mit der das zu verarbeitende Signal führenden Leiterbahn verbunden ist. Anstelle einer pn-Diode kann auch eine MOS-Diode verwendet werden. Es handelt sich dabei um einen MOS-Feldeffekttransistor, dessen Source- und Gateanschlüsse miteinander verbunden sind.

An den Kreuzungspunkten von weiterer, Massepotential führender Leiterbahn und zu verarbeitende Signale führenden Leiterbahnen sind Isolierungen vorzusehen, so daß die beiden Leiterbahnen elektrisch voneinander isoliert sind und ein Kurzschluß zwischen signalführender Leiterbahn des Leadframes und weiterer kreuzender Leiterbahn vermieden wird.

In der Nähe der Kreuzungsorte kann die weitere Leiterbahn einen von ihrer Hauptverlaufsrichtung abzweigenden kurzen Abschnitt aufweisen. Der Abschnitt verläuft zweckmäßigerweise in Richtung zum Halbleiterkörper oder in entgegengesetzter Richtung vom Halbleiterkörper weg. Dieser Abzweig dient als Kontaktfläche für die Anode der ESD-Schutzdiode.

Im Halbleiterkörper, beispielsweise einem Siliziumsubstrat, sind die Funktionseinheiten als bipolare, MOS- oder CMOS-Schaltungen ausgeführt. Eine Eingangsstufe kann aus einem Inverter bestehen. Der Eingangsanschluß des Inverters wird durch die gekoppelten Gate-Anschlüsse seiner komplementären MOS-Transistoren gebildet und ist mit dem zugeordneten Anschlußpad verbunden. Der Source-Anschluß des n-Kanal-MOS-Transistors des Inverters ist mit Bezugspotential Masse verbunden, also an eine Signalleitung im Halbleiterkörper angeschlossen, welche zu demjenigen Anschlußpad führt, welches von der das Bezugspotential führenden Leiterbahn versorgt wird, die ihrerseits wiederum an die weitere, die Leiterbahnen des Leadframes kreuzende Leiterbahn angeschlossen ist.

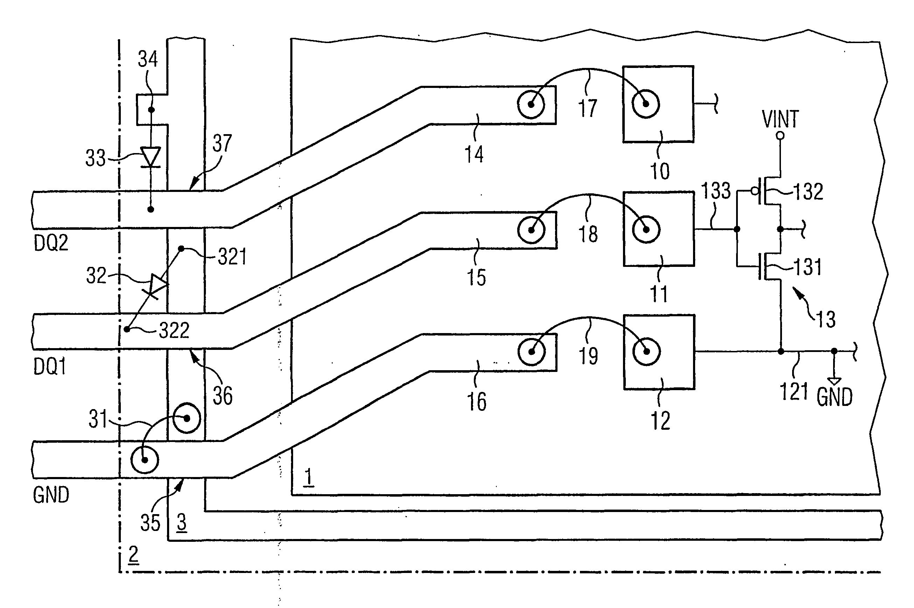

Nachfolgend wird die Erfindung anhand des in der Zeichnung dargestellten Ausführungsbeispiels im Detail erläutert. Die Figur der Zeichnung zeigt einen Halbleiterkörper 1, auf dem eine integrierte Schaltung angeordnet ist. Von der integrierten Schaltung ist auszugsweise eine CMOS-Eingangsschaltstufe 13 dargestellt. Sie umfaßt zweit mit ihren Drain-Source-Strecken in Reihe geschaltete, komplementäre MOS-Transistoren 131, 132. Der p-Kanal-MOS-Transistor 132 wird vom positiven Versorgungspotential VINT versorgt, der Source-Anschluß des n-Kanal-MOS-Transistors 131 wird von Bezugspotential GND versorgt. Das Bezugspotential GND wird durch eine Leitung 121 auf dem Halbleiterchip verteilt. Sämtliche Signale und Versorgungspotentiale werden durch Anschlußpads 10, 11, 12 auf den Halbleiterkörper gebracht. Die Anschlußpads sind flächenhafte Metallisierungen. Die Anschlußpads 10, 11 dienen zur Ein- oder Ausgabe von Datensignalen DQ2 bzw. DQ1. Das Anschlußpad 12 dient zur Zuführung von Massepotential GND. Der Halbleiterchip ist in einem Gehäuse 2 hermetisch eingeschlossen. Der Signalverkehr und die Zuführung von Versorgungsspannung nach außen erfolgt über metallische Leiterbahnen 14, 15, 16. Diese Leiterbahnen sind über Bonddrähte 17, 18 bzw. 19 an ihrem chipseitigen Ende mit den zugeordneten Anschlußpads 10, 11 bzw. 12 verbunden. Sie verlaufen vom Halbleiterchips 1 weg und durch das Gehäuse 2. Die gehäuseaußenseitigen Enden der metallischen Leiterbahnen 14, 15, 16 werden beispielsweise in einen Sockel eingesteckt oder auf einer Schaltungsplatine verlötet. Die Leiterbahnen 14, 15, 16 sind ursprünglich zu einem Leadframe zusammengefaßt, wobei die außenseitigen Enden miteinander verbunden sind. Die Verbindung wird nach der Einkapselung in das Gehäuse 2 weggestanzt.

Gemäß der Erfindung ist eine weitere metallische Leiterbahn 3 vorgesehen. Die Leiterbahn 3 verläuft wie die Leiterbahnen 14, 15, 16 des Leadframes außerhalb des Halbleiterkörpers 1. Im Gegensatz zu den Leiterbahnen 14, 15, 16 des Leadframes verläuft die Leiterbahn 3 nicht vom Chip weg, sondern verläuft parallel zu den Seiten des Halbleiterkörpers 1. Zweckmäßigerweise verläuft die Leiterbahn 3 ringsum jeweils parallel zu den Seiten des Halbleiterkörpers als geschlossener Ring. Die weitere Leiterbahn 3 führt Massepotential GND. Hierzu ist die Leiterbahn 3 am Kreuzungsort von Masseleiterbahn 16 des Leadframes über einen Bonddraht 31 mit dieser verbunden. Alternativ kann auch eine andere Verbindung verwendet werden, durch die die gegenüber liegenden Oberflächen der Leitungen 16, 3 miteinander verbunden werden, beispielsweise durch einen leitfähigen Kleber. Durch die Leitung 3 wird Massepotential GND rings um dem Halbleiterchip 1 bereit gestellt.

Die zusätzliche Leiterbahn 3 kreuzt auch die die Signale DQ1, DQ2 führenden Leiterbahnen 14, 15 des Leadframes. An den Kreuzungsorten sind ESD-Elemente 32, 33 vorgesehen, die zwischen die Leiterbahn 3 und die betreffende der Leiterbahnen 14, 15 geschaltet sind. So ist die Anode einer Diode 32 an der Stelle 321 mit der Leiterbahn 3 verbunden und an der Stelle 322 mit der Leiterbahn 15. Die Diode 32 dient als ESD-Schutzelement. Sie weist eine hohe Durchbruchspannung auf, um das innerhalb der Spezifikation liegende Signal DQ1 nicht zu belasten. Jedoch bei einer hohen elektrostatischen Spannung bricht die Diode 32 durch und ist ausreichend dimensioniert, so daß genügend Ladung von der Leiterbahn 15 über die Kontaktstellen 322, 321 zur Leiterbahn 3 und weiter über den Bonddraht 31 zu der Masseleiterbahn 16 abfließen kann. Dadurch wird das Gateoxid am Transistor 131 des Inverters 13 vor einem Durchbruch geschützt. Im Gegensatz zu auf dem Halbleiterkörper angeordneten ESD-Schutzstrukturen, die zwischen der Eingangsleitung 133 und der Leitung 121 für Massepotential GND anzuordnen wären, verbraucht die ESD-Schutzdiode 32 auf dem Halbleiterkörper keine Fläche. Der Flächenverbrauch wäre nicht unerheblich, da eine hohe Durchbruchspannung bei ausreichender Stromtragfähigkeit erreicht werden müßte.

Die Leiterbahn 14 für das zu verarbeitende Signal DQ2 ist über eine andere ESD-Schutzdiode 33 mit der Ringleiterbahn 3 verbunden. In der Nähe der Kreuzungsstelle von Leiterbahn 14 mit Leiterbahn 3 ist ein Abzweig 34 der Leiterbahn 3 vorgesehen, der parallel zum entsprechenden Abschnitt der Leiterbahn 14 verläuft. Im Ausführungsbeispiel ist der Abzweig 34 nach außen gerichtet, er kann alternativ auch zum Halbleiterkörper 1 hin nach innen gerichtet sein. Der Abzweig 34 ist so weit von der Kreuzungsstelle entfernt, daß die Anode der ESD-Schutzdiode den Abzweig 34 kontaktiert und die Kathode die Leiterbahn 14 kontaktiert.

Im gezeigten Ausführungsbeispiel ist das Signal DQ1 ein solches, welches in die Schaltung auf dem Halbleiterkörper 1 einzugeben ist. Das Signal DQ2 ist beispielsweise ein solches, welches von der Schaltung auszugeben ist. In diesem Fall ist das Anschlußpad 10 mit einem Ausgangstreiber der integrierten Schaltung verbunden, beispielsweise einem Ausgang eines Inverters oder einer Tristate-Stufe. Es ist auch möglich, daß die Signale DQ1, DQ2 bidirektionale Signal sind und sowohl dazu dienen, Daten oder analoge Signale der integrierten Schaltung zuzuführen oder von ihr abzugreifen.

Die Kreuzungsorte von weiterer Metalleiterbahn 3 und signalführenden Leiterbahnen 14, 15 sind so auszuführen, daß ein Kontakt zwischen der Massepotential GND führenden Leiterbahn 3 und den ein Ein-/Ausgangssignal führenden Leiterbahnen 14, 15 verhindert wird. Einerseits kann dies dadurch erreicht werden, daß an den Überkreuzungen die Leiterbahnen ausreichend weit voneinander beabstandet sind. Andererseits ist eine Isolierung 36, 37 zweckmäßig, die zwischen die einander gegenüber liegenden Oberflächen der metallischen Leiterbahnen 3, 15 bzw. 14 angeordnet ist.

Nach dem Bonden der Metalleiterbahnen 14, 15, 16 mittels Bonddrähten 17, 18, 19 an die Anschlußpads 10, 11, 12, dem Verbinden der Leiterbahnen 3, 16 über den Bonddraht 31 und dem Kontaktieren der ESD-Schutzelemente 32, 33 wird die gesamte Anordnung vom Gehäuse 2 umgeben. Damit sind sämtliche Leiterbahnen fixiert, so daß die Verbindung der Leiterbahnen 14, 15, 16 des Leadframes am außenseitigen Ende durch Stanzen entfernt werden kann.

Da für die Schutzelemente 32, 33 eine Flächenbegrenzung nicht mehr zutrifft, können diese vielmehr für höhere Stomtragfähigkeit dimensioniert werden als bei integrierter Realisierung. Dadurch ist es möglich, die ESD-Festigkeit verglichen mit integrierter Realisierung auf dem Halbleiterkörper zu erhöhen.

### Bezugszeichenliste

- 1: Halbleiterkörper
- 2: Gehäuse
- 3: Leiterbahn
- 10, 11, 12: Anschlußpads
- 121: Leitung
- 13: Eingangsstufe
- 131, 132: Transistoren
- 133: Eingang
- 14, 15, 16: Leiterbahnen
- 17, 18, 19, 31: Bonddrähte
- 32, 33: ESD-Schutzdioden
- 321: Anodenanschluß
- 322: Kathodenanschluß
- 34: Leiterbahnabzweig
- 35: Kreuzung
- 36, 37: Isolation
- DQ1, DQ2: zu verarbeitende Signale
- GND: Versorgungspotential
- VINT: Versorgungspotential

## Patentansprüche

1. Halbleiter-Bauelement, umfassend:
- einen Halbleiterkörper (1), in dem eine elektronische Schaltung (13) angeordnet ist, die einen Anschluß (11) für ein zu verarbeitendes Signal (DQ1) aufweist, an den eine Eingangsstufe (13) oder Ausgangsstufe der elektronischen Schaltung angeschlossen ist, und die einen Anschluß (12) für ein Versorgungspotential (GND) aufweist, an den die Eingangsstufe (13) oder die Ausgangsstufe angeschlossen ist,
- je eine einem der Anschlüsse (11, 12) zugeordnete Leiterbahn (15, 16), die außerhalb des Halbleiterkörpers (1) verläuft und die mit dem jeweils zugeordneten Anschluß (11, 12) verbunden ist,
- ein Element (32) zum Abführen elektrostatischer Entladungen, durch das eine am Anschluß (11) für das zu verarbeitende Signal (DQ1) anliegende elektrostatische Entladung zum Versorgungspotential (GND) abführbar ist,
**dadurch gekennzeichnet, daß**
- eine weitere Leiterbahn (3) vorgesehen ist, die außerhalb des Halbleiterkörpers (1) verläuft und die mit der dem Anschluß für das Versorgungspotential (12) zugeordneten Leiterbahn (16) verbunden ist, und daß
- das Element (32) zum Abführen elektrostatischer Ladungen außerhalb des Halbleiterkörpers (1) angeordnet ist und einerseits mit der weiteren Leiterbahn (3) und andererseits mit der dem Anschluß (11) für das zu verarbeitende Signal (DQ1) zugeordneten Leiterbahn (15) jeweils außerhalb des Halbleiterkörpers (1) verbunden ist.

2. Halbleiter-Bauelement nach Anspruch 1,
**gekennzeichnet durch**
ein Gehäuse (2), das den Halbleiterkörper (1) und die weitere Leiterbahn (3) umgibt und das die den Anschlüssen (11, 12) zugeordneten Leiterbahnen (15, 16) teilweise umgibt, so daß ein dem Halbleiterkörper (1) zugewandter Teil dieser Leiterbahnen (15, 16) innerhalb des Gehäuses (2) verläuft und ein dem Halbleiterkörper (1) abgewandter Teil außerhalb des Gehäuse (2) verläuft.

3. Halbleiter-Bauelement nach Anspruch 1 oder 2,
**dadurch gekennzeichnet, daß**
das Element (32) zum Abführen elektrostatischer Entladungen eine Diode ist, deren Anode mit der weiteren Leiterbahn (3) verbunden ist und deren Kathode mit der dem Anschluß (11) für das zu verarbeitende Signal (DQ1) zugeordneten Leiterahn (15) verbunden ist.

4. Halbleiter-Bauelement nach einem der Ansprüche 1 bis 3,
**dadurch gekennzeichnet, daß**
die weitere Leiterbahn (3) den Halbleiterkörper (1) umgibt und daß die den Anschlüssen (10, 11, 12) zugeordneten Leiterbahnen (14, 15, 16) die weitere Leiterbahn kreuzen.

5. Halbleiter-Bauelement nach Anspruch 4,
**dadurch gekennzeichnet, daß**
an den Orten der Kreuzung von der weiteren Leiterbahn (3) mit der dem Anschluß (11) für das zu verarbeitende Signal (DQ1) zugeordneten Leiterbahn (15) eine Isolierung (36) zwischen den sich kreuzenden Leiterbahnen (3, 15) vorgesehen ist.

6. Halbleiter-Bauelement nach einem der Ansprüche 1 bis 5,
**dadurch gekennzeichnet, daß**
die weitere Leiterbahn (3) in der Nähe der Orte der Kreuzung mit der dem Anschluß (10) für ein zu verarbeitendes Signal (DQ1) zugeordneten Leiterbahn (14) einen von ihrer hauptsächlichen Verlaufsrichtung abzweigenden Leiterbahnabschnitt (34) aufweist, an den das Element (33) zum Abführen elektrostatischer Entladungen angeschlossen ist, welches andererseits mit der kreuzenden Leiterbahn (15) verbunden ist.

7. Halbleiter-Bauelement nach einem der Ansprüche 1 bis 6,
**gekennzeichnet durch**
einen Bonddraht (17, 18, 19) **durch** den die den Anschlüssen (10, 11, 12) zugeordneten Leiterbahnen (14, 15, 16) mit den jeweiligen Anschlüssen (10, 11, 12) verbunden sind.

8. Halbleiter-Bauelement nach Anspruch 7,
**dadurch gekennzeichnet, daß**
die Anschlüsse (10, 11, 12) für das zu verarbeitende Signal (DQ1, DQ2) und das Versorgungspotential (GND) im Halbleiterkörper (1) als flächenhafte Metallisierungen angeordnet sind.

9. Halbleiter-Bauelement nach einem der Ansprüche 1 bis 7,
**dadurch gekennzeichnet, daß**
die Eingangsstufe (13) mindestens einen Transistor (131, 132) aufweist, dessen Gate mit dem Anschluß (11) für das zu verarbeitende Signal (DQ1) verbunden ist und dessen Drain- oder Source-Anschluß mit dem Anschluß (12) für das Versorgungspotential (GDN) verbunden ist.

10. Halbleiter-Bauelement nach Anspruch 9,
**dadurch gekennzeichnet, daß**
die Eingangsstufe (13) ein Inverter ist.

## Claims

1. Semiconductor component comprising:
- a semiconductor body (1), in which there is arranged an electronic circuit (13) which has a terminal (11) for a signal (DQ1) to be processed, to which an input stage (13) or output stage of the electronic circuit is connected, and which has a terminal (12) for a supply potential (GND), to which the input stage (13) or the output stage is connected,
- in each case a conductor track (15, 16) which is assigned to one of the terminals (11, 12), runs outside the semiconductor body (1) and is connected to the respectively assigned terminal (11, 12),
- an element (32) for carrying away electrostatic discharges, by which an electrostatic discharge present at the terminal (11) for the signal (DQ1) to be processed can be carried away to the supply potential (GND),
**characterized in that**
- a further conductor track (3) is provided, which runs outside the semiconductor body (1) and is connected to the conductor track (16) assigned to the terminal for the supply potential (12), and **in that**
- the element (32) for carrying away electrostatic charges is arranged outside the semiconductor body (1) and connected on the one hand to the further conductor track (3) and on the other hand to the conductor track (15) assigned to the terminal (11) for the signal (DQ1) to be processed, in each case outside the semiconductor body (1).

2. Semiconductor component according to Claim 1, **characterized by** a package (2), which surrounds the semiconductor body (1) and the further conductor track (3) and which partly surrounds the conductor tracks (15, 16) assigned to the terminals (11, 12), so that a part of these conductor tracks (15, 16) facing toward the semiconductor body (1) runs inside the package (2) and a part facing away from the semiconductor body (1) runs outside the package (2).

3. Semiconductor component according to Claim 1 or 2,
**characterized in that** the element (32) for carrying away electrostatic discharges is a diode, the anode of which is connected to the further conductor track (3) and the cathode of which is connected to the conductor track (15) assigned to the terminal (11) for the signal (DQ1) to be processed.

4. Semiconductor component according to one of Claims 1 to 3, **characterized in that** the further conductor track (3) surrounds the semiconductor body (1) and **in that** the conductor tracks (14, 15, 16) assigned to the terminals (10, 11, 12) cross the further conductor track.

5. Semiconductor component according to Claim 4, **characterized in that**, at the locations where the further conductor track (3) is crossed by the conductor track (15) assigned to the terminal (11) for the signal (DQ1) to be processed, an insulation (36) is provided between the crossing conductor tracks (3, 15).

6. Semiconductor component according to one of Claims 1 to 5, **characterized in that** the further conductor track (3) has in the vicinity of the locations where it is crossed by the conductor track (14) assigned to the terminal (10) for a signal (DQ1) to be processed a conductor track portion (34) branching away from its main running direction, to which there is connected the element (33) for carrying away electrostatic discharges, which on the other hand is connected to the crossing conductor track (15).

7. Semiconductor component according to one of Claims 1 to 6, **characterized by** a bonding wire (17, 18, 19), by which the conductor tracks (14, 15, 16) assigned to the terminals (10, 11, 12) are connected to the respective terminals (10, 11, 12).

8. Semiconductor component according to Claim 7, **characterized in that** the terminals (10, 11, 12) for the signal (DQ1, DQ2) to be processed and the supply potential (GND) are arranged in the semiconductor body (1) as areas of metallization.

9. Semiconductor component according to one of Claims 1 to 7, **characterized in that** the input stage (13) has at least one transistor (131, 132), the gate of which is connected to the terminal (11) for the signal (DQ1) to be processed and the drain or source terminal of which is connected to the terminal (12) for the supply potential (GDN).

10. Semiconductor component according to Claim 9, **characterized in that** the input stage (13) is an inverter.

## Revendications

1. Composant à semi-conducteurs comprenant :
- un corps (1) semi-conducteur dans lequel est disposé un circuit (13) électronique qui a une borne (11) pour un signal (DQ1) à traiter, à laquelle est raccordé un étage (13) d'entrée ou un étage de sortie du circuit électronique, et qui a une borne (12) pour un potentiel (GND) d'alimentation, à laquelle est raccordé l'étage (13) d'entrée ou l'étage de sortie,
- respectivement une piste (15, 16) conductrice associée à l'une des bornes (11, 12), qui s'étend à l'extérieur du corps (1) semi-conducteur et qui est reliée à la borne (11, 12) respectivement associée,
- un élément (32) pour évacuer des décharges électrostatiques, par lequel une décharge électrostatique s'appliquant à la borne (11) pour le signal (DQ1) à traiter peut être évacuée vers le potentiel (GND) d'alimentation,
**caractérisé en ce que**
- il est prévu une autre piste (3) conductrice qui s'étend à l'extérieur du corps (1) semi-conducteur et qui est reliée à la piste (16) conductrice associée à la borne pour le potentiel (12) d'alimentation, et **en ce que**
- l'élément (32) pour l'évacuation des charges électrostatiques est disposé à l'extérieur du corps (1) semi-conducteur et est relié respectivement à l'extérieur du corps (1) semi-conducteur, d'une part, à l'autre piste (3) conductrice et, d'autre part, à la piste (15) conductrice associée à la borne (11) pour le signal (DQ1) à traiter.

2. Composant à semi-conducteurs suivant la revendication 1,
**caractérisé par**
un boîtier (2) qui entoure le corps (1) semi-conducteur et l'autre piste (3) conductrice et qui entoure en partie les pistes (15, 16) conductrices associées aux bornes (11, 12), de manière à ce qu'une partie, tournée vers le corps (1) semi-conducteur, de ces pistes (15, 16) conductrices s'étende à l'intérieur du boîtier (2) et de manière à ce qu'une partie, éloignée du corps (1) semi-conducteur, s'étende à l'extérieur du boîtier (2).

3. Composant à semi-conducteurs suivant la revendication 1 ou 2,
**caractérisé en ce que**
l'élément (32) d'évacuation de décharge électrostatique est une diode dont l'anode est reliée à l'autre piste (3) conductrice et dont la cathode est reliée à la piste (15) conductrice associée à la borne (11) pour le signal (DQ1) à traiter.

4. Composant à semi-conducteurs suivant l'une des revendications 1 à 3,
**caractérisé en ce que**
l'autre piste (3) conductrice entoure le corps (1) semi-conducteur et **en ce que** les pistes (14, 15, 16) conductrices associées aux bornes (10, 11, 12) croisent l'autre piste conductrice.

5. Composant à semi-conducteurs suivant la revendication 4,
**caractérisé en ce que**
à l'emplacement du croisement de l'autre piste (3) conductrice avec la piste (15) conductrice associée à la borne (11) pour le signal (DQ1) à traiter, il est prévu un isolant (36) entre les pistes (3, 15) conductrices qui se croisent.

6. Composant à semi-conducteurs suivant l'une des revendications 1 à 5,
**caractérisé en ce que**
l'autre piste (3) conductrice a, à proximité de l'emplacement du croisement avec la piste (14) conductrice associée à la borne (10) pour un signal (DQ1) à traiter, un tronçon (34) de piste conductrice qui bifurque de sa direction principale de tracé et auquel est raccordé l'élément (33) d'évacuation des décharges électrostatiques, lequel est relié d'autre part à la piste (15) conductrice de croisement.

7. Composant à semi-conducteurs suivant l'une des revendications 1 à 6,
**caractérisé par**
un fil (17, 18, 19) de liaison par lequel les pistes (14, 15, 16) conductrices associées aux bornes (10, 11, 12) sont reliées aux bornes (10, 11, 12) respectives.

8. Composant à semi-conducteurs suivant la revendication 7,
**caractérisé en ce que**
les bornes (10, 11, 12) pour le signal (DQ1, DQ2) à traiter et pour le potentiel (GND) d'alimentation sont disposées dans le corps (1) semi-conducteur sous la forme de métallisations de surface.

9. Composant à semi-conducteurs suivant l'une des revendications 1 à 7,
**caractérisé en ce que**
l'étage (13) d'entrée a au moins un transistor (131, 132) dont la grille est reliée à la borne (11) pour le signal (DQ1) à traiter et dont la borne de drain ou de source est reliée à la borne (12) pour le potentiel (GDN) d'alimentation.

10. Composant à semi-conducteurs suivant la revendication 9,
**caractérisé en ce que**
l'étage (13) d'entrée est un inverseur.
